# EUROPEAN PATENT SPECIFICATION

(11) **EP 4 410 682 B1**
(45) Date of publication and mention of the grant of the patent: **31.12.2025**
(21) Application number: 24152942.9
(22) Date of filing: 19.01.2024
(51) Int. Cl.: B64D 37/32, B64D 37/30, F17C 1/00

(54) **AN AIRCRAFT INERTING SYSTEM**
INERTISIERUNGSSYSTEM FÜR FLUGZEUGE
SYSTÈME D'INERTAGE D'AÉRONEF

(30) Priority: 31.01.2023 GB 202301344
(43) Date of publication of application: 07.08.2024
(73) Proprietor: Airbus Operations Limited, Bristol BS34 7PA (GB)
(72) Inventor: EDWARDS, Henry, Bristol, BS34 7PA (GB); LARKIN, Geoffrey, Bristol, BS34 7PA (GB)
(74) Representative: Ribeiro, James Michael

(56) References cited:
- WO-A1-2022/183267
- US-A- 3 501 050
- US-A- 4 925 057
- US-A1- 2011 290 943
- US-A1- 2015 291 291
- US-B1- 6 343 465

## Description

### FIELD OF THE INVENTION

The present invention relates to an aircraft, a method of mitigating a build-up of fuel vapour and/or oxygen within the aircraft, and a computer-implemented method of designing an aircraft.

### BACKGROUND OF THE INVENTION

Aircraft fuel tanks carry fuel that operates the engines of the aircraft, such as kerosene. As the fuel level drops, the space of the fuel tank which is not occupied by the fuel increases. This space is referred to as the ullage and may be occupied by a mixture of air and kerosene fuel vapour.

Due to the presence of oxygen and fuel vapour, an inerting system is provided to reduce the concentration of oxygen in the ullage and reduce the risk of combustion. To do this, the inerting system feeds an inert gas into the ullage to displace the oxygen rich air.

US 6 343 465 B1 describes a method for using an aircraft's dedicated propulsive or, auxiliary power engines for purging and removing dangerous fuel fumes and heat from within said aircraft's, fuel tank or fuel tank compartment areas with replacement of said fumes and heat by cooler, mechanically refrigerated air or cabin-cockpit outflow air comprising: (a) a duct or conduit means interconnecting said aircraft's fuel tank ullage and fuel tank compartment areas and said aircraft's dedicated engine's outside air intake section for the transmission of said fuel fumes and hot air into said engine's combustion section when said engine is operating, (b) said fuel tank or fuel tank compartment areas containing an inflow valve means wherein mechanically refrigerated or cabin-cockpit outflow air can enter therein, (c) suctioning said dangerous and explosive fuel fumes and heat into said engine's outside air intake then into said combustion section for combustion and exhaust.

### SUMMARY OF THE INVENTION

A first aspect of the invention provides an aircraft comprising: a source of inert gas; a fuel system for containing fuel; a containment area of the aircraft outside the fuel system and configured to contain oxygen and/or fuel vapour leaked from the fuel system; a piccolo tube located in the containment area, the piccolo tube connected to the source of inert gas and configured to flow inert gas from the source of inert gas through holes of the piccolo tube and into the containment area to reduce the concentration of oxygen and/or fuel vapour within the containment area.

With this arrangement, fuel vapour/air that leaks from the fuel system can be removed so as to reduce the fuel vapour/oxygen concentration to an acceptable level.

The fuel system may comprise a fuel cell in a fuel cell enclosure, wherein the containment area is in the fuel cell enclosure.

The containment area may be in an aircraft wing. The containment area may be in an aircraft fuselage. The containment area may be in a fuel pod. The containment area may be in a pylon.

The fuel system may be a hydrogen fuel system for supplying hydrogen fuel.

Hydrogen fuel vapour is more susceptible to escaping from the fuel system and has a low ignition energy and wide flammability range compared to kerosene. It is therefore particularly important to inert containment areas containing hydrogen fuel vapour.

The fuel system may comprise a fuel tank and a fuel line.

The piccolo tube may comprise a first set of holes and a second set of holes, wherein the distribution and/or size of the holes in the first set is different to the second set.

The holes of the piccolo tube may be arranged to direct the inert gas generally upwards so as to bias the flow of inert gas towards an upper zone of the containment area.

The inert gas may be any one of nitrogen enriched air, oxygen depleted air, nitrogen, helium, and carbon dioxide.

The aircraft may comprise a control valve configured to control the flow of inert gas through and/or from the piccolo tube.

The control valve may control the flow of inert gas through an outlet on an end of the piccolo tube.

The control valve may separate a first, upstream section and a second, downstream section of the piccolo tube.

The piccolo tube may comprise two or more channels extending from a main piccolo tube section at a junction, the channels extending to distal zones of the containment area.

The control valve may be located at the junction and configured to control the flow of inert gas through each of the channels.

A second aspect of the invention provides a method of mitigating a build-up of oxygen and/or fuel vapour within the aircraft of the first aspect, comprising: identifying a concentration of oxygen and/or fuel vapour in a zone of the containment area above a predetermined value; and providing a flow of inert gas from the piccolo tube into the containment area to reduce the concentration of oxygen and/or fuel vapour to no more than the predetermined value.

The method may comprise modifying the flow of inert gas from the piccolo tube into the containment area to a minimum flow rate that maintains the concentration of oxygen and/or fuel vapour in the containment area to no more than the predetermined value.

A third aspect of the invention provides a computer-implemented method of designing an aircraft, the method comprising: providing a computational fluid dynamics model of an aircraft, the aircraft comprising a fuel system containing fuel and a containment area outside the fuel system containing oxygen and/or fuel vapour leaked from the fuel system; running the computational fluid dynamics model to simulate a flow of the oxygen and/or fuel vapour within the containment area; identifying a zone of the containment area in which an oxygen and/or fuel vapour concentration is above a predetermined value; and adding a piccolo tube into the containment area or modifying an existing piccolo tube located in the containment area; and running the computational fluid dynamics model to simulate a flow of inert gas through holes of the piccolo tube into the containment area to produce an oxygen and/or fuel vapour concentration in the zone no more than the predetermined value.

With this arrangement, any high concentrations of fuel vapour / oxygen can be identified and dealt with more effectively. The effect of the piccolo tube can also be determined prior to implementation of an aircraft.

The zone may be a first zone, and the method may comprise: re-running the computational fluid dynamics model to simulate the flow of oxygen and/or fuel vapour within the containment area; identifying a second zone of the containment area in which an oxygen and/or fuel vapour concentration is above the predetermined value; and modifying the piccolo tube and/or the flow of inert gas from the piccolo tube to produce an oxygen and/or fuel vapour concentration in the first and second zones no more than the predetermined value.

The computer-implemented method may comprise modifying the piccolo tube to minimise a quantity of the inert gas required to produce an oxygen and/or fuel vapour concentration in the containment area of no more than the predetermined value.

The step of modifying the piccolo tube may comprise at least one of: repositioning the holes of the piccolo tube, resizing the holes of the piccolo tube, resizing a bore diameter of the piccolo tube, modifying the geometry of the holes, modifying the angle of the holes relative to a longitudinal axis of the piccolo tube, and repositioning the piccolo tube in the containment area.

The step of modifying the flow of inert gas may comprise changing a flow rate of the inert gas through the piccolo tube and/or changing the concentration of oxygen in the inert gas (also referred to as the purity of the inert gas).

### BRIEF DESCRIPTION OF THE DRAWINGS

Embodiments of the invention will now be described with reference to the accompanying drawings, in which:
Figure 1 shows an aircraft;
Figure 2 shows a wing of the aircraft including a fuel pod;
Figure 3 shows a wingbox of the wing;
Figure 4 shows a piccolo tube connected to a source of inert gas;
Figure 5 shows an air separation module;
Figure 6 shows a cross-section of the wing, the fuel lines extending through the wing, and the piccolo tube generally following the path of the fuel lines;
Figure 7 shows a perspective view of the fuel lines and piccolo tube extending through the wing;
Figure 8 shows a kerosene fuel tank in the fuselage adjacent a piccolo tube;
Figure 9 shows a hydrogen fuel tank connected to a fuel line in the fuselage with a piccolo tube extending adjacent the fuel lines;
Figure 10 shows a piccolo tube adjacent a fuel pod and generally following the path of the fuel lines from the fuel pod;
Figure 11 shows a fuel cell chamber in which is located a piccolo tube;
Figure 12 shows a representation of the fuel vapour distribution in the fuel cell enclosure in the absence of a piccolo tube;
Figure 13 shows a representation of the fuel vapour distribution in the fuel cell enclosure in the presence of a piccolo tube;
Figure 14 shows a modified piccolo tube in the fuel cell enclosure;
Figure 15 shows a further modified piccolo tube in the fuel cell enclosure;
Figure 16 shows a control valve with the piccolo tube;
Figure 17 shows a variant of the piccolo tube having discrete channels;
Figure 18 shows a variant of the piccolo tube forming a grid pattern;
Figure 19 shows a variant of the piccolo tube defining a pair of channels separated by a central wall, the piccolo tube in a first configuration;
Figure 20 shows a variant of the piccolo tube defining a pair of channels separated by a central wall, the piccolo tube in a second configuration;
Figure 21 shows the piccolo tube forming part of a de-icing system adjacent the leading edge of the wing.

### DETAILED DESCRIPTION OF EMBODIMENT(S)

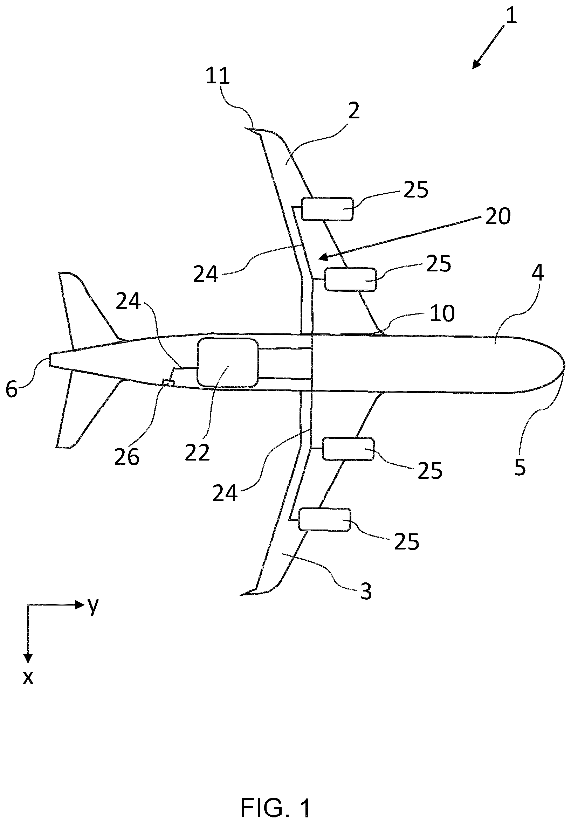

Figure 1 shows an aircraft 1 with port and starboard fixed wings 2, 3, engines 25, a fuselage 4 with a nose end 5 and a tail end 6. The aircraft 1 is a typical jet passenger transonic transport aircraft although the invention is applicable to a wide variety of aircraft types, including commercial, military, passenger, cargo, jet, propeller, general aviation, etc. with any number of engines attached or integral to the wings or fuselage.

Each wing 2, 3 of the aircraft 1 has a cantilevered structure with a length extending in a span-wise direction from a wing root 10 to a wing tip 11, the root 10 being joined to the aircraft fuselage 4.

Endeavours to increase aircraft efficiency and environmental sustainability mean that improvements to existing aircraft are continuously being made, with one such solution being the use of cryogenic fuels such as liquid hydrogen.

Hydrogen may be utilised as an aviation fuel in a number of ways, such as hydrogen direct burn (e.g. a modified gas turbine engine may provide power by burning hydrogen in the turbojet combustion chambers) or converting the hydrogen to electricity by using fuel cell technology in which the electrochemical cell converts the chemical energy of the hydrogen fuel and an oxidising agent into electricity through redox reactions.

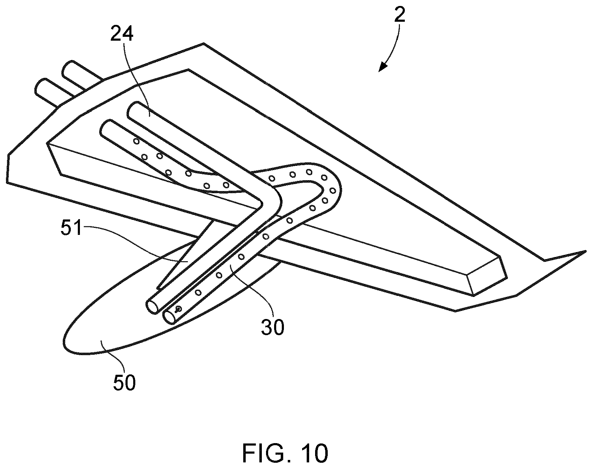

A fuel system 20 including fuel tank(s) 22 and fuel lines 24 is provided to distribute the hydrogen fuel throughout the aircraft 1, as required. The hydrogen tank(s) 22 may be located in any suitable location on the aircraft 1, such as in separate tanks below the wings 2, 3 (e.g. in fuel pods 50 or a pylon 51 - See Figure 10), or in one or more fuel tanks 22 located within or adjacent the fuselage 4. Figure 1 shows a hydrogen fuel tank 22 located towards the rear of the fuselage 4.

The hydrogen fuel lines 24 may be double-walled and extend from the fuel tank(s) 22 to the aircraft power plants (e.g. engines 25 and/or fuel cells 65) so as to channel hydrogen fuel to the power plants, as well as from refuelling ports 26 to the fuel tank(s) 22. The temperatures of cryogenic fuels, such as liquid hydrogen, necessitate double-walled fuel lines 24 in order to form an insulation barrier between the fuel and outer atmosphere.

The fuel system 20 is a pressurised system that seals the hydrogen fuel to prevent it from escaping, however in some situations, for example in the event of a mechanical failure of a portion of the fuel system 20, at least some quantity of fuel vapour can leak and collect in areas of the aircraft 1 outside of the fuel system 20 of the aircraft 1. The low ignition energy and wide flammability range of hydrogen, relative to fuels such as kerosene, increases the importance of preventing a build-up of hydrogen fuel vapour and/or oxygen within the aircraft 1.

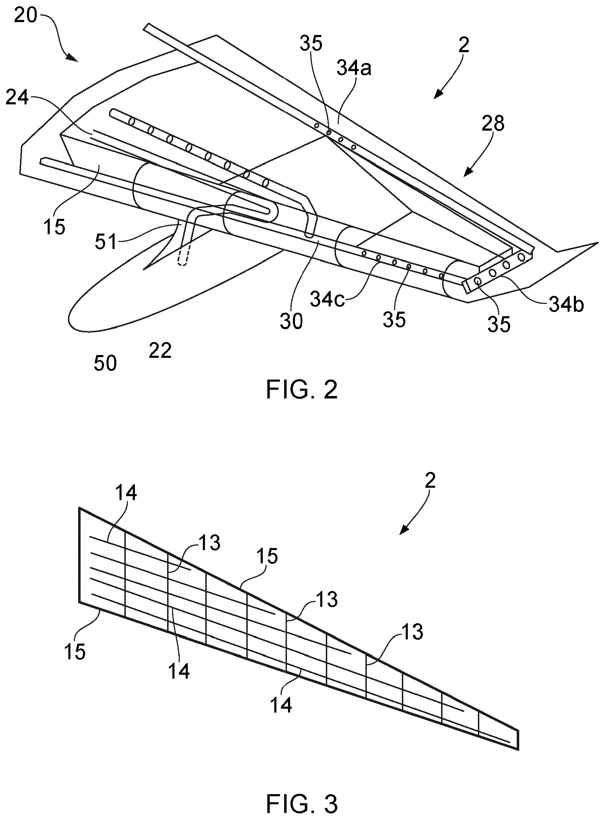

Figure 2 shows a port side wing 2 of the aircraft 1. A fuel pod 50 containing a fuel tank 22 is suspended beneath the wing 2. The fuel tank 22 contains hydrogen fuel and forms part of a fuel system 20 with fuel lines 24 extending through the wing 2 from the fuel tank 22. A containment area 28 is defined within the wing 2 that includes the total area of the wing 2 (for example - the area bounded by the aircraft wing skin) excluding the fuel system 20. The containment area 28 defines a boundary outside the fuel system 20 but inside the aircraft 1 (or a section of the aircraft 1) that may passively collect fuel vapours that leak from the fuel system 20, e.g. from the fuel tank 22, that can ignite in the presence of oxygen (or other oxidisers). The fuel vapour and/or oxygen may be able to escape the containment area 28, i.e. the containment area 28 is not a closed system, however escape from the containment area 28 is sufficiently restricted that the fuel vapour and oxygen may collect in high concentrations in zones/regions of the containment area 28. This is particularly the case when the containment area 28 defines a complex geometry that causes variable flow rates throughout the containment area, with fuel vapour and oxygen more likely to collect in particular parts of the containment area 28.

For instance, a concentration of fuel vapour and/or oxygen may build-up in a particular zone of the containment area 28 above a predetermined 'allowable' value(s). To reduce the concentration of fuel vapour and/or oxygen in this zone to an acceptable value, a flow of inert gas can be directed towards the zone to disperse and displace the fuel vapour and oxygen. For instance, the zone may be a stagnant zone of the containment area 28 in which any movement of the fuel vapour or oxygen is minimal, thereby causing a build-up of fuel vapour or oxygen. Injecting a flow of inert gas towards the stagnant zone energises the stagnant fuel vapours and oxygen, with the inert gas forcing at least a portion of the fuel vapours and oxygen away from the stagnant zone and eventually out of the containment area 28 (e.g. to atmosphere).

This can be achieved effectively with the use of an inerting system comprising a piccolo tube 30 (alternatively referred to as a distribution tube). A piccolo tube 30 is a tube having a plurality of holes 35 in the wall of the tube. Typically, a piccolo tube 30 will have tens or hundreds of holes 35 along its length.

The wing 2 typically spans tens of metres and will include various structures, such as ribs 13, stiffeners 14, spars 15, and associated fixtures, such as shown in Figure 3. The wing 2 also includes pipework, such as fuel lines 24 and associated fixtures. This creates areas in which pockets of fuel vapour or oxygen can readily accumulate at concentrations above acceptable levels - often in distal parts of the containment area 28.

The piccolo tube 30 can be tailored to maximise its effectiveness whilst minimising its complexity compared to an equivalent system that would require multiple nozzles on the ends of separate inert gas lines. The piccolo tube 30 provides a single inert gas line that can be fed from a single source of inert gas whilst reaching all required areas of the containment area 28 by outputting the inert gas through the plurality of output holes 35 along its length. For instance, Figure 2 shows the piccolo tube 30 extending from the wing root 10, along the trailing edge to the wing tip 11, and along the leading edge of the wing 2.

In addition, the position (radially and longitudinally), angle relative to the longitudinal axis of the piccolo tube 30, and/or size of the holes 35 can be tailored to focus on particular zones of the containment area 28 in which high concentrations of fuel vapour might be expected. For instance, Figure 2 shows the piccolo tube 30 comprising a first set 34a of holes 35 adjacent the trailing edge, a second set 34b of holes 35 adjacent the wing tip 11, and a third set 34c of holes 35 adjacent the leading edge.

Each of the sets 34a, 34b, 34c may be tailored in terms of its position, the distribution of the holes 35 within the sets 34a, 34b, 34c, and the size of the holes 35 within the sets 34a, 34b, 34c. For instance, the size of the holes 35 in the first set 34a may be different to the size of the holes 35 in the second and third sets 34b, 34c, and so on. A set is defined as a plurality of holes 35, and may include more than ten or twenty holes.

With this arrangement, oxygen levels and/or leaks of fuel vapour in the containment area 28 from the fuel system 20 can be kept to within acceptable levels, minimising the risk of any combustible mixture.

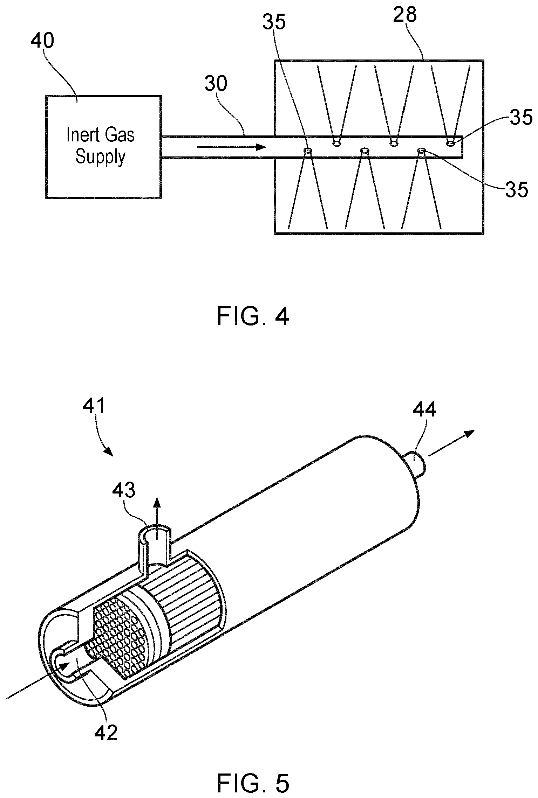

Figure 4 shows the piccolo tube 30 connected to a source of inert gas 40. The source of inert gas 40 may include an "On Board Inert Gas Generation System" (OBIGGS) having an air separation module 41 (ASM), such as shown in Figure 5, which is arranged to take air (e.g. from the engine bleed system) through an inlet 42 and use a membrane within the ASM to separate the oxygen from the incoming flow. In this way, two streams of gas are produced. An oxygen enriched air that can be diverted overboard through a first outlet 43, and a nitrogen enriched air (also referred to as oxygen depleted air) that can be directed to the piccolo tube 30 for distribution through a second outlet 44. Air separation modules 41 are known and currently used to produce inert gas for the ullage of existing kerosene fuel tanks.

It will be appreciated that other sources of inert gas 40 may be provided, including onboard storage tanks carrying the inert gas. Nitrogen enriched air is only one example of a suitable inert gas, with others including oxygen depleted air, helium, nitrogen gas and carbon dioxide, with many other gases suitable for displacing the fuel vapours whilst reducing the risk of ignition within the containment area 28. It will be appreciated that the inert gas 40 may be any suitable gas for reducing the risk of ignition within the containment area 28 and will largely depend on the type of fuel.

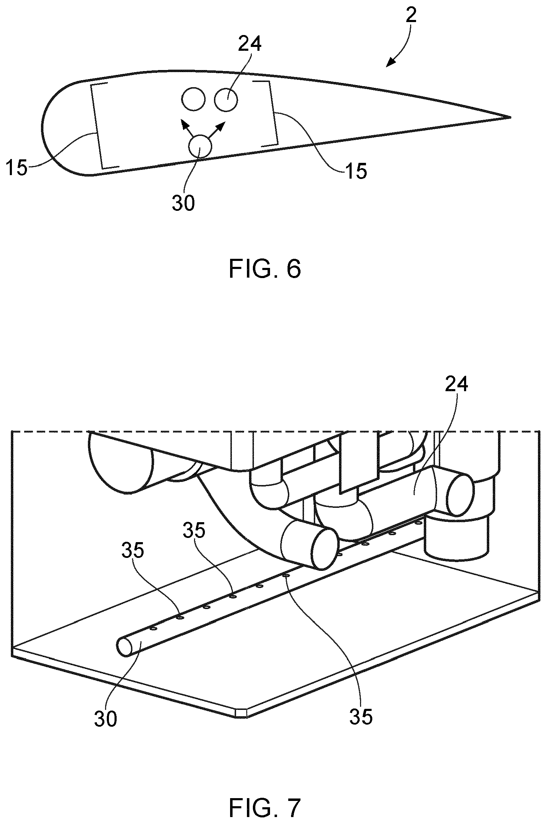

The example shown in Figure 2 refers to a fuel tank 22 that may leak fuel vapours, however it can be expected that fuel lines 24 will also leak fuel vapours. Figures 6 and 7 show the fuel lines 24 extending through a portion of the wing 2, with a piccolo tube 30 arranged to project a flow of inert gas towards the fuel lines 24 so as to wash out any build-up of hydrogen fuel vapour and/or oxygen.

As hydrogen gas is lighter than many gases, including atmospheric gas, the hydrogen gas will typically accumulate towards an upper zone of the containment area 28 with atmospheric air accumulating below the hydrogen fuel vapours. Consequently, improved performance may be found in positioning the piccolo tube 30 below the hydrogen fuel lines 24 and positioning the holes 35 to direct the inert gas at a generally upwards trajectory or angling the central axis of the holes at an acute angle relative to the longitudinal axis of the piccolo tube 30. For instance, Figures 6 and 7 show the holes 35 of the piccolo tube 30 oriented at +/- 10 degrees from the vertical direction. The holes 35 may be distributed within a 90 degree arc. In contrast, for kerosene fuel vapours or other denser fuel vapours, and dependent on the relative density of the inert gas and fuel vapours, it might be expected to more evenly distribute the inert gas, or to direct the inert gas generally downwards.

The piccolo tube 30, and in particular the holes 35 of the piccolo tube 30, may be positioned to coincide with the fuel lines 24, any discontinuities in the fuel line 24 where an increased risk of fuel leaks can be expected, or the interspaces within the containment area such as aft of the rear spar and forward of the front spar.

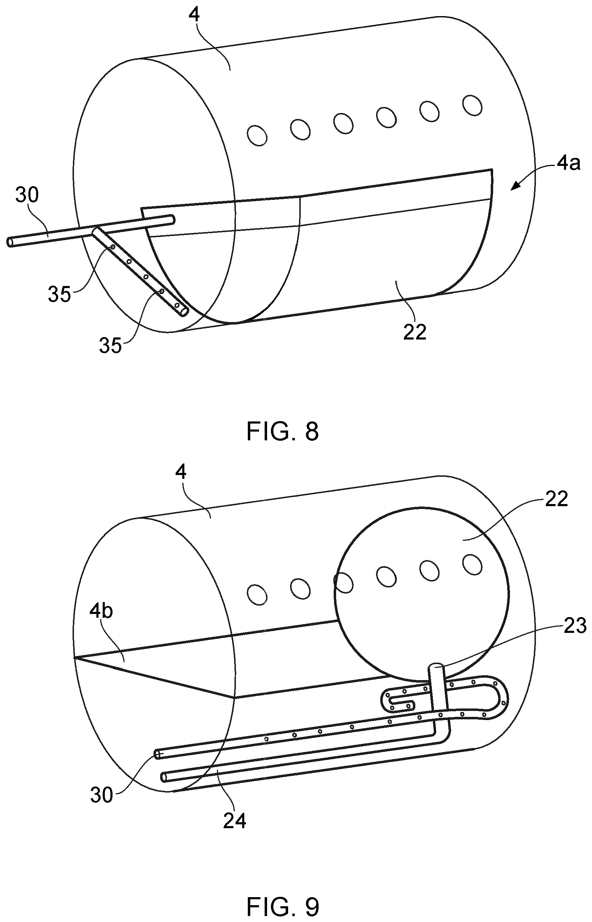

In an aircraft 1 in which the fuel tanks 22 (e.g. centre fuel tanks and auxiliary fuel tanks) and/or fuel lines 24 are located in the fuselage 4, the piccolo tube 30 may be positioned to extend through the fuselage 4. Figure 8 shows a kerosene fuel tank 22 placed in the cargo area 4a, although it will be appreciated the fuel tank 22 may be suitably modified so as to contain hydrogen fuel, whilst Figure 9 shows a hydrogen fuel tank 22 above the cabin floor 4b of the fuselage 4, although it will be appreciated the fuel tank 22 may be in any suitable location within the fuselage 4. In each case, the piccolo tube 30 extends adjacent the fuel tank 22 so as to displace any fuel vapours leaked from the fuel tanks 22. In the example of Figure 9, the piccolo tube 30 is shown to extend generally parallel to a length of the fuel line 24. In addition, the piccolo tube 30 wraps around the fuel line 24 adjacent the connection 23 between the fuel tank 22 and the fuel line 24, so as to concentrate a larger proportion of the inert gas at the connection 23 where additional fuel vapour leakages might be expected. Alternatively, or additionally, the holes 35 of the piccolo tube 30 may be more densely packed adjacent the connection 23.

In some examples, the aircraft 1 may include one or more fuel pods 50 for storing fuel. Figure 10 shows a wing pod 50 attached to the port wing 2, with a fuel line 24 extending from the fuel pod 50. A piccolo tube 30 is channelled so as to extend through the pylon 51, and adjacent and along a length of the fuel line 24.

As previous discussed, the engines 25 may be powered by direct burn of the hydrogen or by converting the hydrogen to electricity using a fuel cell 65.

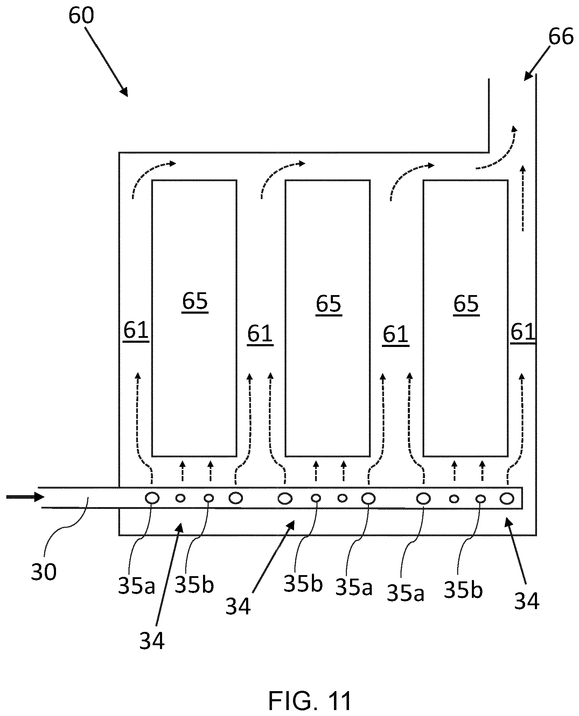

Figure 11 shows a fuel cell enclosure 60 containing fuel cells 65, specifically three fuel cells 65, although the fuel cell enclosure 60 may contain any suitable number of fuel cells 65. The fuel cells 65 are part of a power generation system of the aircraft 1 and are not considered part of the fuel system 20.

A piccolo tube 30 is positioned within the fuel cell enclosure 60 and arranged to propel inert gas through the holes 35 of the piccolo tube 30, through the fuel cell enclosure 60, and out through the outlet 66. In this way, the oxygen in the fuel cell enclosure 60 as well as fuel vapour leaked from the fuel cells 65 into the fuel cell enclosure 60 can be washed away through the outlet 66.

As illustrated in Figure 11, the position and size of the holes 35 of the piccolo tube 30 can be configured so as to most efficiently prevent stagnant fuel vapour zones and remove the fuel vapour from the fuel cell enclosure 60. In particular, a set 34 of four holes 35 is associated with each fuel cell 65, with outer holes 35a having a greater aperture size than inner holes 35b of each set 34e so as to increase flow in the channels 61 between the fuel cells 65.

The arrangement of the piccolo tube 30 and inert gas flow may be designed for a specified location on the aircraft 1, so as to non-uniformly distribute the inert gas throughout the containment area 28 in a manner that is biased towards those areas prone to having higher concentrations of fuel vapour and/or oxygen.

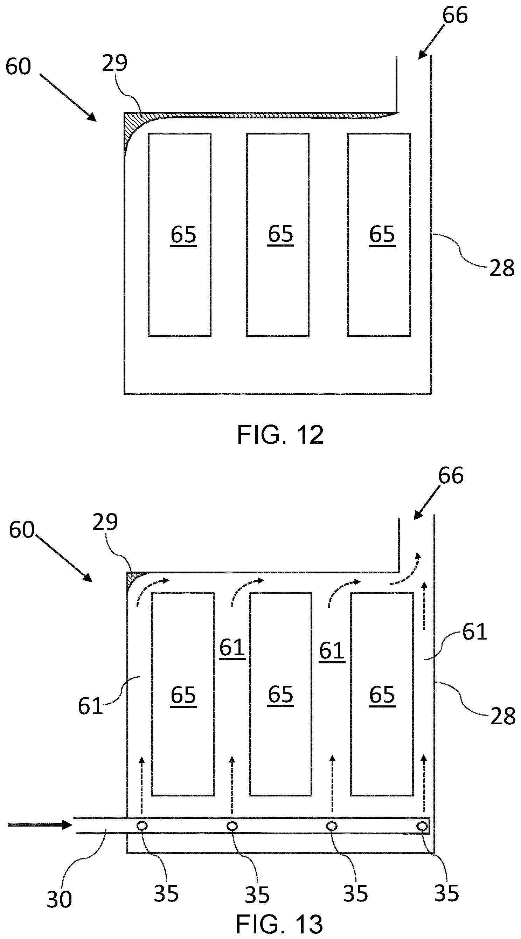

This can be achieved at a design phase, as will be discussed below, by modelling the aircraft 1 (or a part of the aircraft 1, such as the wing 2, fuselage 4, or fuel cell enclosure 60) as a computational fluid dynamics (CFD) model. The model simulates the flow of fuel vapour and/or oxygen within the containment area 28, taking into account the expected leaks from the fuel system 20. In this way, an accurate model of the zone(s) 29 of the containment area 28 in which high concentrations of fuel vapour are expected can be obtained (See Figure 12).

The identified zones 29 can be used to determine the configuration of a piccolo tube 30 within the containment area 28. For example, a piccolo tube 30 may be provided that has holes 35 directed along the channels 61 of the fuel cell enclosure 60, thereby focussed on areas of the fuel cell enclosure 60 in which high fuel vapour concentrations can be expected, and thereby mitigated by the flow of inert gas from the piccolo tube 30.

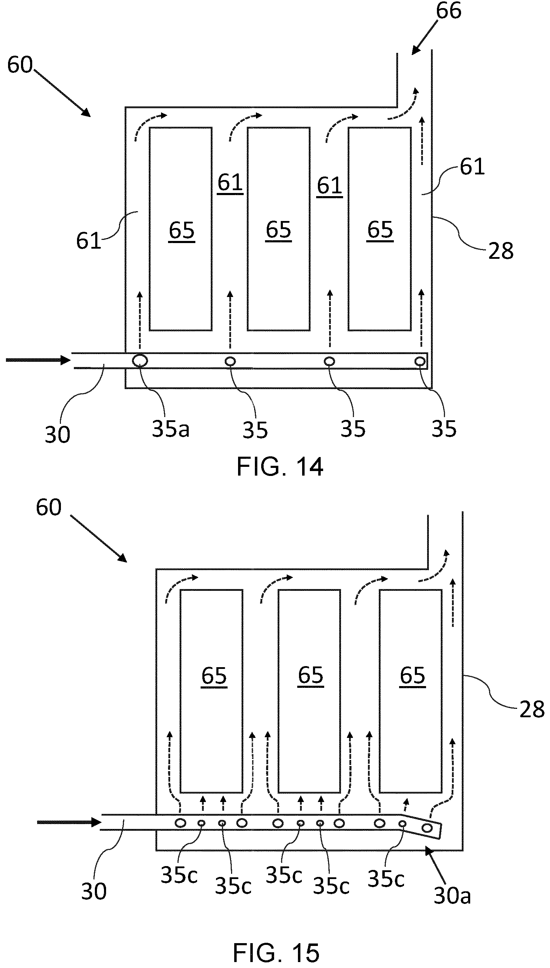

Further to this, the model can be refined to improve the flow of inert gas from the piccolo tube 30. For instance, Figure 13 shows stagnant zones 29 in the fuel cell enclosure 60 in which the concentration of fuel vapour remains above an acceptable level, for instance a determined 'safe limit'. The piccolo tube 30 may thus be redesigned, and/or the flow rates through the piccolo tube modified, so as to improve the circulation of gas flow through the containment area 28, and thereby ensure the containment area 28 does not contain any pockets of fuel vapour in which the concentration is above an acceptable level. In the example shown in Figure 14, the one of the holes 35a has been increased in size to increase the flow rate in this area and reduce the concentration of fuel vapour at the stagnation zone 29 previously described in relation to Figure 13.

Producing the required quantity of inert gas can be a significant drain on resources. In a subsequent step, the piccolo tube 30 may be further modified so as to optimise the performance of the piccolo tube 30, thereby minimising the flow rate of inert gas and/or the overall quantity of inert gas required to effectively manage the concentration of fuel vapour throughout the containment area 28. Figure 15 shows an example of a further iteration to the design of the piccolo tube 30 in which the size of some of the holes 35c has been decreased, whilst the route through the containment area 28 of the piccolo tube 30 is altered (See the end section 30a of the piccolo tube 30).

In service, the delivery of the inert gas to the containment area 28 through the piccolo tube 30 may be similarly modified. For instance, the inert gas may be supplied intermittently, or at varying flow rates dependent on requirements, so as to conserve resources.

As an example, a concentration of fuel vapour and/or oxygen in a zone of the containment area 28 may be identified as being above a predetermined value. In response, a flow of inert gas can be directed through the piccolo tube 30 so as to reduce the concentration of fuel vapour or oxygen to an acceptable level, or an existing flow rate of the system may be increased so as to reduce the concentration of fuel vapour or oxygen. The flow rate of inert gas may then be modified to find a minimum flow rate that ensures that there are no areas within the containment area 28 having a fuel vapour or oxygen concentration above the predetermined value, whilst minimising the use of inert gas.

In the preceding discussion, modifying the piccolo tube may refer to any one or more of: repositioning one or more of the holes 35 of the piccolo tube 35, resizing one or more of the holes 35 of the piccolo tube 30, modifying the angle of the holes 35 relative to the longitudinal axis of the piccolo tube 30, resizing the diameter of the bore of the piccolo tube 30, or repositioning the piccolo tube 30 or a part of the piccolo tube 30 in the containment area 28. Modifying the flow of gas may comprise changing the flow rate of the inert gas, either to a constant flow rate or intermittently as required, or restricting the flow of gas to sections of the piccolo tube 30, as will be discussed below.

In some examples, one or more control valves 70 may be provided along the length of the piccolo tube 30 or at the end of the piccolo tube 30. The control valve 70 can be used to control the flow of inert gas through and/or from the piccolo tube 30. This can allow real-time modification of the gas flow so that zones of the containment area 28 can be targeted intermittently, or in isolated cases when high concentrations of fuel vapour would otherwise be unexpected. This can allow inert gas to be conserved, as well as allowing additional inert gas to be redistributed where and when it is needed most.

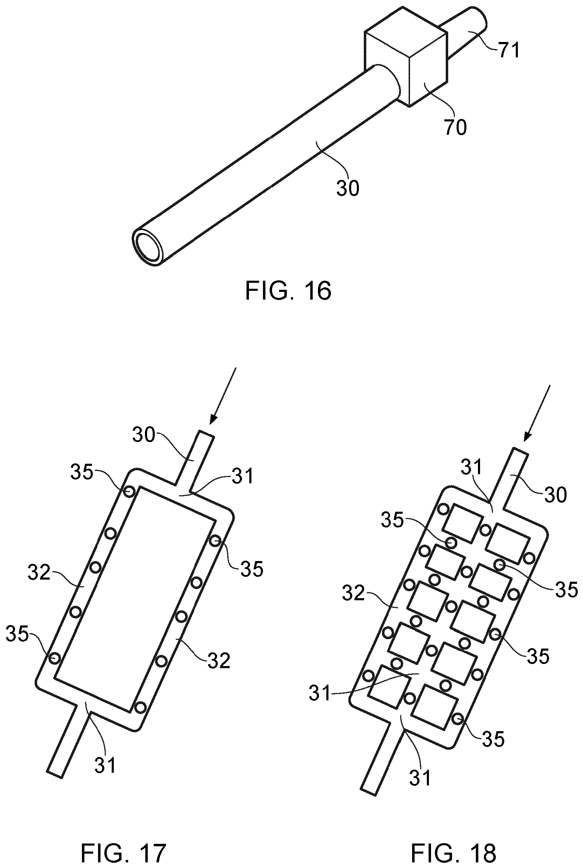

Figure 16 shows a control valve 70 at the end of a piccolo tube 30 separating the piccolo tube 30 from an outlet 71. The control valve 70 can be intermittently opened and closed to reduce the pressure in the piccolo tube 30, or to direct a large stream of inert gas through the outlet 71 in a particular direction. The inert gas directed through the outlet 71 may be used to cool down or heat up a hot component of the aircraft 1, as well as serve its primary purpose of inerting the containment area 28.

Alternatively, or in addition, the piccolo tube 30 may include a control valve 70 along its length so as to separate a first, upstream, section of the piccolo tube 30 from a second, downstream, section of the piccolo tube 30 so as to selectively vary the flow rate along the length of the piccolo tube 30.

Whilst the abovementioned examples of piccolo tubes 30 describe a single line configuration having a single central axis, in alternative examples the piccolo tube 30 may have multiple junctions 31 that extend into separate channels 32, with the separate channels 32 able to more effectively cover a given area of the containment area 28 than multiple piccolo tubes 30 or a piccolo tube 30 with a single central axis. An example is shown in Figure 17, in which the piccolo tube 30 comprises a junction 31 that splits the piccolo tube 30 into first and second channels 32. The piccolo tube 30 may include a further junction 31 that reconnects the channels further down the piccolo tube 30, or the channels 32 may remain separated.

With such an arrangement, each of the channels 32 can extend to different sections of the containment area 28 whilst being connected to a common source of inert gas 40. The path of the respective channels 32 can be tailored to maximum the effect of the piccolo tube 30 within a given containment area 28, as can the size and distribution of the holes 35 in each of the channels 32.

The flow rate in each of the channels 32 can be tailored. For instance, the bore sizes of the channels 32 may differ so as to create different flow rates in the channels 32, and/or a control valve 70 may be positioned along one or both of the channels 32, or at the junction 31, to allow the flow rate in each channel 32 to be varied independently in use.

The piccolo tube 30 may have various configurations, for example Figure 18 shows a grid pattern arrangement of the piccolo tube 30 in which multiple channels 32 intersect at junctions 31 to form the grid pattern. This can allow large volumes of inert gas to be distributed more evenly over a particular area of the containment area 28.

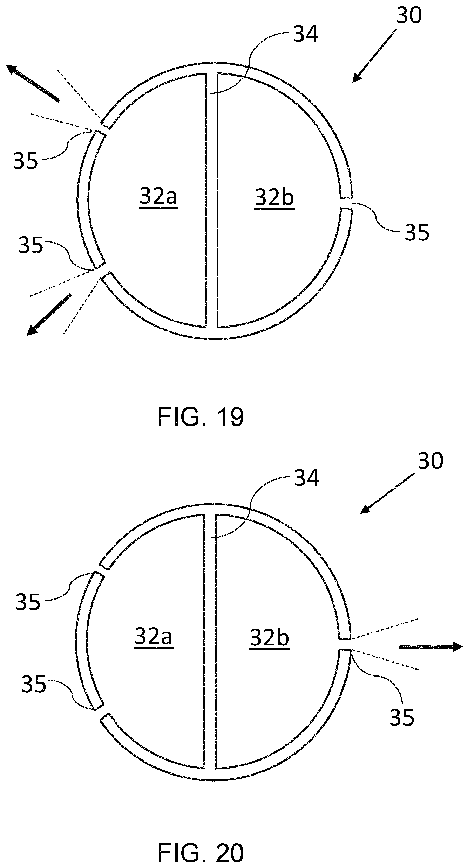

The channels 32 may form part of a common piccolo tube 30, such as shown in Figure 19 in which the piccolo tube 30 includes a first channels 32a and a second channel 32b separated by a wall 33.

The first channel 32a has two holes 35, one at an 8 'o clock position and the other at 10 'o clock. The second channel 32b has one hole 35 at a 3 o' clock position. A control system, e.g. including a control valve 70, may be arranged to selectively switch the flow of inert gas between the channels 32a, 32b, or to allow the flow of inert gas through both channels simultaneously 32a, 32b. The channels 32a, 32b may function similarly to the channels 32 described in relation to Figures 17 and 18, except that the channels 32a, 32b form part of a common bore of the piccolo tube 30 and are therefore more tightly packed.

With the use of multiple channels 32, 32a, 32b and/or the separation of upstream and downstream sections of the piccolo tube 30 in combination with a control system, the outflow from the piccolo tube 30 can be more effectively managed.

The control of the flow of inert gas may be tailored based on the particular flight phase, for example such that a first channel 32a is activated at a first flight phase such as during cruise (See Figure 19) and a second channel 32b is activated at a second flight phase such as climb (See Figure 20).

The flow of inert gas may be tailored based on the orientation of the aircraft 1, which can change in-flight (e.g. due to gust loads or aircraft manoeuvres such as pitch and roll). For example, the vector of the inert gas flow may be altered relative to the aircraft structure so as to direct the inert gas towards regions in which the fuel vapour or oxygen is expected to accumulate. For instance, in hydrogen gas systems the inert gas may be directed upwards. This arrangement may include a controller that actively controls the flow direction of the inert gas or may be a passive system that uses (e.g.) gravitational forces to redirect the flow of inert gas.

Such selective use of the piccolo tube 30 can allow the inert gas to be used more efficiently and effectively, reducing the burden on the system (e.g. the ASM) so as to potentially improve its operational reliability and extend its service life.

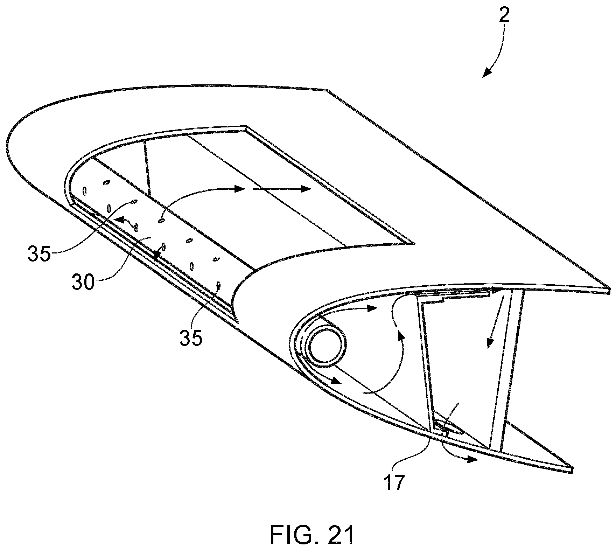

In some examples, the piccolo tube 30 may serve multiple functions. Piccolo tubes 30 are known to be used as an anti-icing system at the leading edge 16 of aircraft wings 2 (See Figure 21). A piccolo tube 30 is fed with heated engine bleed air so as to prevent the accumulation of ice at the leading edge 16, with the holes 35 concentrated on the leading edge 16 region of the wing 2. The bleed air contains a similar oxygen concentration to atmospheric air (i.e. around 21%), however this high oxygen content air may be substituted with an inert gas so as to provide the dual function of de-icing and inerting the containment area 28 of the wing 2. It is expected that a piccolo tube 30 designed to perform this dual function would need to be adapted so as to function as an inerting system, particularly as the current de-icing systems are arranged with flow paths that direct the flow out through exhaust holes 17 or similar arrangements, rather than encouraging the flow to circulate through the wing 2. It is further noted that the flow rate for inerting the containment area 28 is expected to be many times greater than the flow rate required for de-icing the leading edge 16 and appropriate modifications may need to be made to account for this, e.g. the use of multiple air separation modules 41.

Whilst the invention has been described in regard to hydrogen fuel due to its low ignition energy, the examples may be similarly applicable to other fuels such as ammonia fuel and sustainable aviation fuels (SAF). The examples may also be appliable to kerosene fuel systems in some cases, particularly in isolated regions of the aircraft 1 where kerosene fuel vapours may collect. It will be appreciated that the composition of the inert gas may be varied dependent on the fuel.

In such cases where the fuel tank 22 is not pressurised, the piccolo tube 30 may also extend into the fuel tank 22 to circulate inert gas into the ullage of the fuel tank 22.

Where the word 'or' appears this is to be construed to mean 'and/or' such that items referred to are not necessarily mutually exclusive and may be used in any appropriate combination.

Although the invention has been described above with reference to one or more preferred embodiments, it will be appreciated that various changes or modifications may be made without departing from the scope of the invention as defined in the appended claims.

## Claims

1. An aircraft (1) comprising:
a source of inert gas (40);
a fuel system (20) for containing fuel;
a containment area (28) of the aircraft (1) outside the fuel system (20) and configured to contain oxygen and/or fuel vapour leaked from the fuel system (20); and
a piccolo tube (30) located in the containment area (28), the piccolo tube (30) connected to the source of inert gas (40) and configured to flow inert gas from the source of inert gas through holes (35) of the piccolo tube (30) and into the containment area (28) to reduce the concentration of oxygen and/or fuel vapour within the containment area (28).

2. The aircraft (1) of claim 1, wherein the fuel system (20) comprises a fuel cell (65) in a fuel cell enclosure (60), wherein the containment area (28) is in the fuel cell enclosure (60) or wherein the containment area (28) is in an aircraft wing, aircraft fuselage, fuel pod or pylon.

3. The aircraft (1) of any preceding claim, wherein the fuel system (20) is a hydrogen fuel system for supplying hydrogen fuel and/or the fuel system (20) comprises a fuel tank (22) and a fuel line (24).

4. The aircraft (1) of any preceding claim, wherein the piccolo tube (30) comprises a first set of holes (35a) and a second set of holes (35b), wherein the distribution and/or size of the holes (35a) in the first set is different to the second set (35b) and/or wherein the holes (35) of the piccolo tube (30) are arranged to direct the inert gas generally upwards so as to bias the flow of inert gas towards an upper zone of the containment area (28).

5. The aircraft (1) of any preceding claim, wherein the inert gas is any one of nitrogen enriched air, oxygen depleted air, nitrogen, helium, and carbon dioxide.

6. The aircraft (1) of any preceding claim, comprising a control valve (70) configured to control the flow of inert gas through and/or from the piccolo tube (30).

7. The aircraft (1) of claim 6, wherein the control valve (70) controls the flow of inert gas through an outlet on an end of the piccolo tube (30) or the control valve (70) separates a first, upstream section and a second, downstream section of the piccolo tube (30).

8. The aircraft (1) of any preceding claim, wherein the piccolo tube (30) comprises two or more channels (32) extending from a main piccolo tube section at a junction (31), the channels (32) extending to distal zones of the containment area (28), optionally wherein the control valve (70) is located at the junction (31) and configured to control the flow of inert gas through each of the channels (32).

9. A method of mitigating a build-up of oxygen and/or fuel vapour within the aircraft (1) of any one of claims 1 to 8, comprising:
identifying a concentration of oxygen and/or fuel vapour in a zone of the containment area (28) above a predetermined value; and
providing a flow of inert gas from the piccolo tube (30) into the containment area (28) to reduce the concentration of oxygen and/or fuel vapour to no more than the predetermined value.

10. The method of claim 9, comprising:
modifying the flow of inert gas from the piccolo tube (30) into the containment area (28) to a minimum flow rate that maintains the concentration of oxygen and/or fuel vapour in the containment area (28) to no more than the predetermined value.

11. A computer-implemented method of designing an aircraft (1), the method comprising:
providing a computational fluid dynamics model of an aircraft (1), the aircraft comprising a fuel system (20) containing fuel and a containment area (28) outside the fuel system (20) containing fuel vapour and/or air leaked from the fuel system (20);
running the computational fluid dynamics model to simulate a flow of the oxygen and/or fuel vapour within the containment area (28);
identifying a zone of the containment area (28) in which an oxygen and/or fuel vapour concentration is above a predetermined value; and
adding a piccolo tube (30) into the containment area (28) or modifying an existing piccolo tube (30) located in the containment area (28); and
running the computational fluid dynamics model to simulate a flow of inert gas through holes (35) of the piccolo tube (30) into the containment area (28) to produce an oxygen and/or fuel vapour concentration in the zone no more than the predetermined value.

12. The computer-implemented method of claim 11, wherein the zone is a first zone, the method comprising:
re-running the computational fluid dynamics model to simulate the flow of oxygen and/or fuel vapour within the containment area (28);
identifying a second zone of the containment area (28) in which a fuel vapour and/or oxygen concentration is above the predetermined value; and
modifying the piccolo tube (30) and/or the flow of inert gas from the piccolo tube (30) to produce an oxygen and/or fuel vapour concentration in the first and second zones no more than the predetermined value.

13. The computer-implemented method of any one of claims 12, wherein the step of modifying the flow of inert gas comprises changing a flow rate of the inert gas through the piccolo tube (30) and/or changing the concentration of oxygen in the inert gas.

14. The computer-implemented method of any one of claims 11 to 13, comprising modifying the piccolo tube (30) to minimise a quantity of the inert gas required to produce an oxygen and/or fuel vapour concentration in the containment area (28) of no more than the predetermined value.

15. The computer-implemented method of any one of claims 11 to 14, wherein the step of modifying the piccolo tube (30) comprises at least one of: repositioning the holes (35) of the piccolo tube (30), resizing the holes (35) of the piccolo tube (30), resizing a bore diameter of the piccolo tube (30), and repositioning the piccolo tube (30) in the containment area (28).

## Patentansprüche

1. Luftfahrzeug (1), das Folgendes umfasst:
eine Inertgasquelle (40);
ein Kraftstoffsystem (20), um Kraftstoff zu enthalten;
einen Eindämmungsbereich (28) des Luftfahrzeugs (1) außerhalb des Kraftstoffsystems (20) und dazu ausgelegt, Sauerstoff und/oder Kraftstoffdampf, die aus dem Kraftstoffsystem (20) lecken, einzudämmen; und
ein Piccolorohr (30), das sich in dem Eindämmungsbereich (28) befindet, wobei das Piccolorohr (30) mit der Inertgasquelle (40) verbunden ist und dazu ausgelegt ist, Inertgas von der Inertgasquelle durch Löcher (35) des Piccolorohrs (30) und in den Eindämmungsbereich (28) fließen zu lassen, um die Konzentration von Sauerstoff und/oder Kraftstoffdampf innerhalb des Eindämmungsbereichs (28) zu reduzieren.

2. Luftfahrzeug (1) nach Anspruch 1, wobei das Kraftstoffsystem (20) eine Kraftstoffzelle (65) in einer Kraftstoffzelleneinhausung (60) umfasst, wobei sich der Eindämmungsbereich (28) in der Kraftstoffzelleneinhausung (60) befindet oder wobei sich der Eindämmungsbereich (28) in einem Luftfahrzeugflügel, Luftfahrzeugrumpf, einem Kraftstoffmodul oder einem Pylon befindet.

3. Luftfahrzeug (1) nach einem der vorhergehenden Ansprüche, wobei das Kraftstoffsystem (20) ein Wasserstoffkraftstoffsystem zum Zuführen von Wasserstoffkraftstoff ist und/oder das Kraftstoffsystem (20) einen Kraftstofftank (22) und eine Kraftstoffleitung (24) umfasst.

4. Luftfahrzeug (1) nach einem der vorhergehenden Ansprüche, wobei das Piccolorohr (30) einen ersten Satz von Löchern (35a) und einen zweiten Satz von Löchern (35b) umfasst, wobei sich die Verteilung und/oder Größe der Löcher (35a) in dem ersten Satz von dem zweiten Satz (35b) unterscheidet und/oder wobei die Löcher (35) des Piccolorohrs (30) angeordnet sind, um das Inertgas allgemein nach oben zu richten, um den Fluss von Inertgas in Richtung einer oberen Zone des Eindämmungsbereichs (28) vorab zu beeinflussen.

5. Luftfahrzeug (1) nach einem der vorhergehenden Ansprüche, wobei das Inertgas eines von stickstoffangereicherter Luft, sauerstoffabgereicherter Luft, Stickstoff, Helium und Kohlendioxid ist.

6. Luftfahrzeug (1) nach einem der vorhergehenden Ansprüche, das ein Steuerventil (70) umfasst, das dazu ausgelegt ist, den Inertgasfluss durch und/oder von dem Piccolorohr (30) zu steuern.

7. Luftfahrzeug (1) nach Anspruch 6, wobei das Steuerventil (70) den Inertgasfluss durch einen Auslass an einem Ende des Piccolorohrs (30) steuert oder das Steuerventil (70) einen ersten, stromaufwärtigen Abschnitt und einen zweiten, stromabwärtigen Abschnitt des Piccolorohrs (30) trennt.

8. Luftfahrzeug (1) nach einem der vorhergehenden Ansprüche, wobei das Piccolorohr (30) zwei oder mehr Kanäle (32) umfasst, die sich von einem Hauptpiccolorohrabschnitt an einer Verbindungsstelle (31) erstrecken, wobei sich die Kanäle (32) zu distalen Zonen des Eindämmungsbereichs (28) erstrecken, wobei sich gegebenenfalls das Steuerventil (70) an der Verbindungsstelle (31) befindet und dazu ausgelegt ist, den Inertgasfluss durch jeden der Kanäle (32) zu steuern.

9. Verfahren zum Entgegenwirken einer Anreicherung von Sauerstoff und/oder Kraftstoffdampf innerhalb des Luftfahrzeugs (1) nach einem der Ansprüche 1 bis 8, umfassend:
Identifizieren einer Konzentration von Sauerstoff und/oder Kraftstoffdampf in einer Zone des Eindämmungsbereichs (28) über einem vorbestimmten Wert; und
Bereitstellen eines Inertgasflusses aus dem Piccolorohr (30) in den Eindämmungsbereich (28), um die Konzentration von Sauerstoff und/oder Kraftstoffdampf auf nicht mehr als den vorbestimmten Wert zu reduzieren.

10. Verfahren nach Anspruch 9, das Folgendes umfasst:
Modifizieren des Inertgasflusses aus dem Piccolorohr (30) in den Eindämmungsbereich (28) auf eine minimale Flussrate, die die Konzentration von Sauerstoff und/oder Kraftstoffdampf in dem Eindämmungsbereich (28) auf nicht mehr als den vorbestimmten Wert hält.

11. Computerimplementiertes Verfahren zum Design eines Luftfahrzeugs (1), wobei das Verfahren Folgendes umfasst:
Bereitstellen eines rechnerischen Fluiddynamikmodells eines Luftfahrzeugs (1), wobei das Luftfahrzeug ein Kraftstoffsystem (20), das Kraftstoff enthält, und einen Eindämmungsbereich (28) außerhalb des Kraftstoffsystems (20) umfasst, der Kraftstoffdampf und/oder Luft enthält, die aus dem Kraftstoffsystem (20) lecken;
Ausführen des rechnerischen Fluiddynamikmodells, um einen Fluss des Sauerstoffs und/oder des Kraftstoffdampfs innerhalb des Eindämmungsbereichs zu simulieren (28);
Identifizieren einer Zone des Eindämmungsbereichs (28), in der eine Sauerstoff- und/oder Kraftstoffdampfkonzentration über einem vorbestimmten Wert liegt; und
Hinzufügen eines Piccolorohrs (30) in den Eindämmungsbereich (28) oder Modifizieren eines vorhandenen Piccolorohrs (30), das sich in dem Eindämmungsbereich (28) befindet; und
Ausführen des rechnerischen Fluiddynamikmodells, um einen Inertgasfluss durch Löcher (35) des Piccolorohrs (30) in den Eindämmungsbereich (28) zu simulieren, um eine Sauerstoff- und/oder Kraftstoffdampfkonzentration in der Zone zu produzieren, die den vorbestimmten Wert nicht überschreitet.

12. Computerimplementiertes Verfahren nach Anspruch 11, wobei die Zone eine erste Zone ist, wobei das Verfahren Folgendes umfasst:
erneutes Ausführen des rechnerischen Fluiddynamikmodells, um den Fluss von Sauerstoff und/oder Kraftstoffdampf innerhalb des Eindämmungsbereichs zu simulieren (28);
Identifizieren einer zweiten Zone des Eindämmungsbereichs (28), in der eine Kraftstoffdampf- und/oder Sauerstoffkonzentration über dem vorbestimmten Wert liegt; und
Modifizieren des Piccolorohrs (30) und/oder des Inertgasflusses aus dem Piccolorohr (30), um eine Sauerstoff- und/oder Kraftstoffdampfkonzentration in der ersten und zweiten Zone zu produzieren, die den vorbestimmten Wert nicht überschreitet.

13. Computerimplementiertes Verfahren nach einem der Ansprüche 12, wobei der Schritt des Modifizierens des Inertgasflusses Ändern einer Flussrate des Inertgases durch das Piccolorohr (30) und/oder Ändern der Sauerstoffkonzentration in dem Inertgas umfasst.

14. Computerimplementiertes Verfahren nach einem der Ansprüche 11 bis 13, umfassend Modifizieren des Piccolorohrs (30), um eine Menge des Inertgases zu minimieren, die erforderlich ist, um eine Sauerstoff- und/oder Kraftstoffdampfkonzentration in dem Eindämmungsbereich (28) von nicht mehr als dem vorbestimmten Wert zu produzieren.

15. Computerimplementiertes Verfahren nach einem der Ansprüche 11 bis 14, wobei der Schritt des Modifizierens des Piccolorohrs (30) mindestens eines von Neupositionieren der Löcher (35) des Piccolorohrs (30), Größenanpassung der Löcher (35) des Piccolorohrs (30), Größenanpassung eines Bohrungsdurchmessers des Piccolorohrs (30) und Neupositionieren des Piccolorohrs (30) in dem Eindämmungsbereich (28) umfasst.

## Revendications

1. Aéronef (1) comprenant :
une source de gaz inerte (40) ;
un système de carburant (20) destiné à contenir du carburant ;
une zone de confinement (28) de l'aéronef (1) située à l'extérieur du système de carburant (20) et conçue pour contenir de l'oxygène et/ou de la vapeur de carburant issue du système de carburant (20) ; et
un tube Piccolo (30) situé dans la zone de confinement (28), le tube Piccolo (30) étant raccordé à la source de gaz inerte (40) et conçu pour faire circuler du gaz inerte provenant de la source de gaz inerte à travers des trous (35) du tube Piccolo (30) et jusqu'à l'intérieur de la zone de confinement (28) afin de réduire la concentration d'oxygène et/ou de vapeur de carburant à l'intérieur de la zone de confinement (28).

2. Aéronef (1) de la revendication 1, dans lequel le système de carburant (20) comprend une pile à combustible (65) dans une enceinte de pile à combustible (60), la zone de confinement (28) se trouvant dans l'enceinte de pile à combustible (60) ou bien la zone de confinement (28) se trouvant dans une aile d'aéronef, un fuselage d'aéronef, une réserve de carburant ou un pylône.

3. Aéronef (1) d'une quelconque revendication précédente, dans lequel le système de carburant (20) est un système de combustible hydrogène destiné à fournir du combustible hydrogène et/ou le système de carburant (20) comprend un réservoir de carburant (22) et une conduite de carburant (24).

4. Aéronef (1) d'une quelconque revendication précédente, dans lequel le tube Piccolo (30) comprend un premier ensemble de trous (35a) et un deuxième ensemble de trous (35b), dans lequel la répartition et/ou la taille des trous (35a) du premier ensemble sont différentes de celles du deuxième ensemble (35b) et/ou dans lequel les trous (35) du tube Piccolo (30) sont agencés pour diriger le gaz inerte généralement vers le haut de manière à privilégier la circulation de gaz inerte vers une région supérieure de la zone de confinement (28).

5. Aéronef (1) d'une quelconque revendication précédente, dans lequel le gaz inerte est n'importe quel gaz parmi l'air enrichi en azote, l'air appauvri en oxygène, l'azote, l'hélium et le dioxyde de carbone.

6. Aéronef (1) d'une quelconque revendication précédente, comprenant une vanne de commande (70) conçue pour réguler la circulation de gaz inerte à travers et/ou depuis le tube Piccolo (30).

7. Aéronef (1) de la revendication 6, dans lequel la vanne de commande (70) régule la circulation de gaz inerte à travers une sortie sur une extrémité du tube Piccolo (30) ou bien la vanne de commande (70) sépare une première section, amont et une deuxième section, aval du tube Piccolo (30).

8. Aéronef (1) d'une quelconque revendication précédente, dans lequel le tube Piccolo (30) comprend au moins deux canaux (32) s'étendant depuis une section principale de tube Piccolo au niveau d'une jonction (31), les canaux (32) s'étendant jusqu'à des régions distales de la zone de confinement (28), éventuellement dans lequel la vanne de commande (70) se situe à la jonction (31) et est conçue pour réguler la circulation de gaz inerte à travers chacun des canaux (32).

9. Procédé d'atténuation d'une accumulation d'oxygène et/ou de vapeur de carburant à l'intérieur de l'aéronef (1) de l'une quelconque des revendications 1 à 8, comprenant :
l'identification, dans une région de la zone de confinement (28), d'une concentration d'oxygène et/ou de vapeur de carburant supérieure à une valeur prédéterminée ; et
la mise en place d'une circulation de gaz inerte depuis le tube Piccolo (30) jusqu'à l'intérieur de la zone de confinement (28) pour réduire la concentration d'oxygène et/ou de vapeur de carburant à une valeur ne dépassant pas la valeur prédéterminée.

10. Procédé de la revendication 9, comprenant :
le passage de la circulation de gaz inerte depuis le tube Piccolo (30) jusqu'à l'intérieur de la zone de confinement (28) à un débit minimal qui maintient la concentration d'oxygène et/ou de vapeur de carburant dans la zone de confinement (28) à une valeur ne dépassant pas la valeur prédéterminée.

11. Procédé de conception d'un aéronef (1) mis en œuvre par ordinateur, le procédé comprenant :
l'obtention d'un modèle informatique de dynamique des fluides d'un aéronef (1), l'aéronef comprenant un système de carburant (20) contenant du carburant et une zone de confinement (28) à l'extérieur du système de carburant (20) contenant de la vapeur de carburant et/ou de l'air ayant fui du système de carburant (20) ;
l'exécution du modèle informatique de dynamique des fluides pour simuler une circulation de l'oxygène et/ou de la vapeur de carburant à l'intérieur de la zone de confinement (28) ;
l'identification d'une région de la zone de confinement (28) dans laquelle une concentration d'oxygène et/ou de vapeur de carburant est supérieure à une valeur prédéterminée ; et
l'ajout d'un tube Piccolo (30) dans la zone de confinement (28) ou modifier un tube Piccolo existant (30) situé à l'intérieur de la zone de confinement (28) ; et
l'exécution du modèle informatique de dynamique des fluides pour simuler une circulation de gaz inerte à travers des trous (35) du tube Piccolo (30) jusqu'à l'intérieur de la zone de confinement (28) afin de générer dans la région une concentration d'oxygène et/ou de vapeur de carburant ne dépassant pas la valeur prédéterminée.

12. Procédé mis en œuvre par ordinateur de la revendication 11, dans lequel la région est une première région, le procédé comprenant :
la réexécution du modèle informatique de dynamique des fluides pour simuler la circulation d'oxygène et/ou de vapeur de carburant à l'intérieur de la zone de confinement (28) ;
l'identification d'une deuxième région de la zone de confinement (28) dans laquelle une concentration de vapeur de carburant et/ou d'oxygène est supérieure à la valeur prédéterminée ; et
la modification du tube Piccolo (30) et/ou de la circulation de gaz inerte depuis le tube Piccolo (30) pour générer dans les première et deuxième régions une concentration d'oxygène et/ou de vapeur de carburant ne dépassant pas la valeur prédéterminée.

13. Procédé mis en œuvre par ordinateur de l'une quelconque des revendications 12, dans lequel l'étape de modification de la circulation de gaz inerte comprend la modification d'un débit du gaz inerte à travers le tube Piccolo (30) et/ou la modification de la concentration d'oxygène dans le gaz inerte.

14. Procédé mis en œuvre par ordinateur de l'une quelconque des revendications 11 à 13, comprenant la modification du tube Piccolo (30) pour minimiser la quantité de gaz inerte nécessaire pour générer dans la zone de confinement (28) une concentration d'oxygène et/ou de vapeur de carburant ne dépassant pas la valeur prédéterminée.

15. Procédé mis en œuvre par ordinateur de l'une quelconque des revendications 11 à 14, dans lequel l'étape de modification du tube Piccolo (30) comprend au moins une des opérations suivantes : repositionnement des trous (35) du tube Piccolo (30), redimensionnement des trous (35) du tube Piccolo (30), redimensionnement d'un diamètre d'alésage du tube Piccolo (30), et repositionnement du tube Piccolo (30) dans la zone de confinement (28).
